Europäisches Patentamt

European Patent Office

Office européen des brevets

(19)

(11) **EP 0 367 750 B1**

(12) **EUROPÄISCHE PATENTSCHRIFT**

(45) Veröffentlichungstag und Bekanntmachung des Hinweises auf die Patenterteilung:
**01.05.1996  Patentblatt 1996/18**

(51) Int Cl.[6]: **H01L 21/306**

(21) Anmeldenummer: **89890238.2**

(22) Anmeldetag: **13.09.1989**

(54) **Verfahren zur Herstellung einer Siliziummenbran mit kontrollierter Spannung**

Process for producing a silicon membrane with controlled mechanical stress

Procédé de fabrication d'une membrane de silicium à tension mécanique contrôlée

(84) Benannte Vertragsstaaten:
**AT BE CH DE FR GB IT LI NL SE**

(30) Priorität: **13.09.1988  US 243816**

(43) Veröffentlichungstag der Anmeldung:
**09.05.1990  Patentblatt 1990/19**

(73) Patentinhaber:
- **IMS Ionen Mikrofabrikations Systeme Gesellschaft m.b.H.
A-1020 Wien (AT)**
- **NANOSTRUCTURES, INC.
Mountain View California 94043 (US)**

(72) Erfinder: **Mauger, Philip E.
Mountain View California 94043 (US)**

(74) Vertreter: **Matschnig, Franz, Dipl.-Ing. et al
Siebensterngasse 54
Postfach 252
A-1070 Wien (AT)**

(56) Entgegenhaltungen:
**US-A- 3 418 226          US-A- 3 801 390**

- **THE BELL SYSTEM TECHNICAL JOURNAL, März 1970, Seiten 473-475**
- **EXTENDED ABSTRACTS, Bd. 82-1, Mai 1982, Seiten 192-193, Zusammenfassung Nr. 122, Pennington, New Jersey, US; J.F. BLACK et al.: "Studies of Boron- and Boron + Germanium Doped Epitaxial Silicon Films For Ultrathin Silicon Diaphragms"**
- **JOURNAL OF THE ELECTROCHEMICAL SOCIETY, Bd. 133, Nr. 8, August 1986, Seiten 1724-1729, Manchester, NH, US; P.M. SARRO et al.: "Silicon Cantilever Beams Fabricated by Electrochemically Controlled Etching for Sensor Applications"**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

ANWENDUNGSBEREICH DER ERFINDUNG

Die Erfindung betrifft die Erzeugung von Siliziummembranen und insbesondere ein Herstellungsverfahren, bei dem der Spannungsgrad in der Membran genau kontrolliert werden kann.

STAND DER TECHNIK

Dünne Membranen aus Einkristallsilizium können in einer Reihe von Anwendungsbereichen eingesetzt werden, wie beispielsweise bei Masken für röntgenlithografische Belichtungen von integrierten Schaltungen, Schattenoder Channeling-Masken für Teilchenstrahlen (wie Ionen oder Elektronen), Fenstern zur atmosphärischen Abdichtung, verformbaren optischen und mechanischen Elementen, Sensoren und Wandlern, oder bei Substraten für die Herstellung von Halbleiterbauelementen.

Silizium-Wafer werden gewöhnlich durch Schneiden von dünnen Scheiben aus Einkristall-Rohlingen hergestellt. Danach werden die Scheiben unter Anwendung von bekannten chemisch-mechanischen Schleif- und Polierverfahren dünner gemacht und poliert. Wafer sind in einer Dicke von 76 µm (0,003 Zoll) oder stärker erhältlich, wobei meistens eine Dicke von 380-640 µm (0,015 - 0,025 Zoll) gewählt wird. Bei einer Dicke von weniger als 76 µm (0,003 Zoll) zeigen die chemisch-mechanischen Verdünnungsmethoden keine guten Ergebnisse, so daß anstelle dessen chemische Ätzverfahren angewendet werden. In der Regel wird nicht der ganze Wafer in seiner Dicke reduziert, da danach die Bruchgefahr zu groß wäre. Statt dessen werden nur Teile des Wafers dünner gemacht. Jene Teile des Wafers, deren Dicke nicht reduziert werden soll, werden mit einer inaktiven Maskierungsschicht versehen, die sie gegen das Einwirken der Ätzlösung schützt. Die dabei erzielten Strukturen, die aus chemisch dünngeätzten Silizium-Wafern gebildet sind, werden zwecks Unterscheidung vom Ausgangsmaterial eines Wafers als Membrane bezeichnet. Diese Membrane sind für Anwendungsbereiche geeignet, in denen Siliziumdicken benötigt werden, die geringer sind als jene, die durch chemisch-mechanisches Polieren erzielt werden können, d.h. unter ca. 76 µm (0,003 Zoll).

Am einfachsten wird eine Membran aus einem Silizium-Wafer durch das Zeit-Ätzverfahren erzeugt. Dabei wird der Wafer zuerst auf jenen Teilen des Wafers mit einer Maskierungsschicht versehen, auf denen eine Ätzung vermieden werden soll. Danach wird der Wafer in die Ätzlösung eingetaucht, welche dann das Silizium von den nicht maskierten Flächen entfernt. Wenn die Ätzrate des Siliziums in der verwendeten Lösung bekannt ist, und wenn die Ätzrate aller zu ätzenden Bereiche des Wafers gleichmäßig ist, kann der Wafer einfach so lange in die Lösung eingetaucht werden, wie dies für die Reduzierung auf eine bestimmte Dicke des Wafers erforderlich ist. Die größten Nachteile bei dieser Verfahrenstechnik liegen darin, daß eine genaue Kontrolle der Ätzrate und das Erzielen einer hohen Gleichmäßigkeit nur schwer möglich sind.

Zur Lösung der Schwierigkeiten bei der Kontrolle der Ätzrate beim Zeit-Ätzverfahren wurden eine Reihe von Ätzstopptechniken entwickelt. Am häufigsten wird die $p^{++}$ Ätzstopptechnik angewendet. Diese Technik beruht darauf, daß die Ätzrate von Silizium in Alkalilösungen beträchtlich sinkt, wenn die Dotierungsstärke von Bor etwa $5 \times 10^{19}$ pro $cm^3$ übersteigt. Diese Technik wurde beschrieben im US-Patent 4,256,532, erteilt an Magdo, et al., und im US-Patent Nr. 4,589,952, erteilt an Behringer, et al. Die Anwendung dieser Verfahrenstechnik zur Erzeugung von Masken, die für den Einsatz in der Lithografie mit maskierten Ionenstrahlen geeignet sind, wird von G.M.Atkinson, et al., beschrieben in "A minimum step fabrication process for the all-silicon channeling mask", Journal of Vacuum Science Technology, Jan/Feb 1987, pp.219-222.

Um mit dem $p^{++}$ Ätzstoppverfahren eine Membran herzustellen, wird eine Fläche des Silizium-Wafers mit einer bordotierten Schicht versehen. Danach wird der Wafer geätzt, wobei auf der anderen Seite begonnen wird. Wenn die Ätzlösung zur Grenzfläche gelangt, die durch die bordotierte Schicht festgelegt ist, wird der Ätzvorgang infolge Sinkens der Ätzrate abgebrochen. Die Dicke der Membran wird somit durch die Dicke der bordotierten Beschichtung bestimmt. Da die höchste Löslichkeit von Bor in Silizium etwa $1 \times 10^{20}$ pro $cm^3$ ist, muß die Bordotietierungsstärke der fertigen Membran im Bereich von etwa $0.5 - 1 \times 10^{20}$ pro $cm^3$ liegen. Ein ähnliches Verfahren zur Erzeugung einer Membran, vorzugsweise durch Ätzen von $n^+$ Silizium, ist im US-Patent Nr.3,713,922, erteilt an Lepselter, et al., dargestellt.

Eine andere Ätzstopptechnik ist der pn elektrochemische Ätzstopp (ECE). In diesem Fall wird im Silizium-Wafer ein pn-Übergang gebildet. Einige bekannte Techniken hiefür sind Diffusion, Ionenimplantation oder Epitaxie. Durch das Anlegen einer geeigneten elektrischen Spannung an den Wafer kann an der durch den pn-Übergang festgelegten Grenzfläche der Ätzvorgang am Silizium gestoppt werden. Dabei wird die Dicke der Membran durch die Lage des pn-Übergangs bestimmt.

Die ECE-Technik ist von S.A.Waggener in "Electrochemically controlled thinning of silicon", The Bell System Technical Journal, March, 1970, pp 473 - 475, allgemein beschrieben. Die ursprüngliche, von Waggener beschriebene Technik wurde erweitert durch die Verwendung anderer Alkaliätzmittel als Ersatz für KOH (siehe T.N. Jackson, et al., "An electrochemical p-n junction etch-stop for the formation of silicon microstructures", IEEE Electron Device Letters, Vol.EDL-2, No. 2,February 1981, pp.44-45, und M.Hirata, et al., "A silicon diaphragm formation for pressure sensor by anodic oxidation etch-stop", IEEE Conference Proceedings of Transducers 1985, June 1985, pp.287-290) und durch die Verwendung von Mehrelektroden-Vorspannungsanordnungen (siehe US-Patent 4,664,762, erteilt an Hirata und B.Kloek, et al., "A novel four electrode electrochemical etch-stop method for silicon membrane formation", IEEE Conference Proceedings of Transducers 1987, June 1987, pp. 116-119). Die ECE-Technik kann zur Erzeugung großflächiger Membranen bei guter Gleichmäßigkeit und genauer Kontrolle der Dicke angewendet werden.

Die Kontrolle der Spannung ist in vielen Einsatzbereichen von Membranen wichtig. Bei Röntgenmasken ist beispielsweie eine Membran mit hoher Zugspannung vorteilhaft. Dadurch kann die Membran möglichst flach sein und ihre Verformungsbeständigkeit wird verbessert, wenn auf eine Fläche Metallabsorberstrukturen aufgebracht werden. Für Schattenmasken ist eine Membran mit geringer, aber nicht verschwindender Zugspannung am besten geeignet. Dadurch bleibt die Membran flach und etwaige Verformungen werden bei der Bildung der Schablonenlöcher weitgehendst ausgeschaltet.

Die Empfindlichkeit einer Membran gegen einen Druckunterschied zwischen den beiden Flächen wird auch durch ihren Spannungsgrad beeinflußt. Dies ist bei der Verwendung von Membranen als Fenster oder für bestimmte Sensoren von Bedeutung. Die Bruchbeständigkeit der Membran bei mechanischen Schwingungen, Stößen oder Kräften wird ebenfalls durch den Spannungsgrad beeinflußt. Die Qualität eines Halbleiterbauelements ist auch oft eine Funktion des Spannungsgrades im Siliziummaterial. Deshalb ist die Eignung einer Membran für die Verwendung in einem Halbleiterbauelement auch von der Spannung in der Membran abhängig.

Über die Auswirkung des Dotierungsmaterials auf den Spannungsgrad in Silizium-Wafern wurden verschiedene Untersuchungen vorgenommen (siehe M. Sasiki, et al., "A study of strain in ion implanted silicon", Semiconductor Processing, ASTM STP 850, American Society for Testing and Materials, 1984, pp.96-109; N. Sato, "X-ray measurement of lattice strain induced by impurity diffusion", Journal of the Physical Society of Japan, Vol.38, No. 1, Jan.1975, pp.202-207; und K.Yagi, et al, "Anouralous diffusion of phosphorous into silicon", Japanese Journal of Applied Physics, Japan, Vol. 9, No. 3, March 1970, pp.246-254). Diese Untersuchungen bezogen sich auf die Auswirkungen von Spannung auf die Eigenschaften der diffundierten oder implantierten Schicht. Bei diesen Untersuchungen wurde eine Röntgenanalyse von dotierten Wafern durchgeführt, um die Gitterspannung für verschiedene Arten und Konzentrationen von Dotierungsmaterialien zu messen. Diese zeigt, daß der Grad der erzeugten Spannung von der Größe des Dotierungsatoms abhängig ist. Bor und Phosphor, die kleiner sind als Silizium, bewirken eine Zugspannung. Arsen, das fast die gleiche Größe wie Silizium besitzt, bewirkt nur eine geringfügige Druckspannung. Größere Atome wie Antimon bewirken eine Druckspannung. Die Spannung wird bei größerer Dotierungskonzentration erhöht, bis eine Höchstgrenze erreicht ist. An diesem Punkt kommt es zu einer Versetzung. Jede weitere Dotierungssubstanz, die dann noch hinzugesetzt wird, verursacht nur noch mehr Versetzungen, ohne daß die Spannung noch stärker wird. Die vorher erwähnte Untersuchung betrifft lediglich die Auswirkungen auf die Spannung in ganzen Wafern und berücksichtigt nicht etwaige Zusammenhänge dieses physikalischen Effekts mit der Erzeugung von Membranen.

In dem Dokument EXTENDED ABSTRACTS , Band 82-1, Mai 1982, Seiten 192-193, Zusammenfassung Nr. 122, Pennington, New Jersey, US; J.F. BLACK et al.: "Studies of boron- and boron + germanium doped epitaxial silicon films for utrathin silicon diaphragms" ist ein naßchemisches Ätzverfahren beschrieben. Da für einen naßchemischen Ätzstop in nachteiliger Weise eine hohe Bordotierung erforderlich ist, wird in diesem Dokument vorgeschlagen, bei Aufbringen einer Epitaxieschicht zusätzlich zur Bordotierung (zugleich) auch Germanium beizugeben, um die aus der Bordotierung resultierende hohe Versetzungsdichte zu verringern und eine möglichst spannungsfreie Membran herstellen zu können.

Das Dokument JOURNAL OF THE ELECTROCHEMICAL SOCIETY, Band 133, Nr. 8, August 1986, Seiten 1724-1729, Manchester, NH, US; P.M. SARRO et al.: "Silicon cantilever beams fabricated by electrochemically controlled etching for sensor applications" beschreibt die Herstellung eines freitragenden Trägers in einem Siliziumsubstrat, auf welchem integrierte Schaltungen ausgebildet sind. In diesem Dokument D3 ist geoffenbart, daß die für eine Schaltungslogik aufgebrachten Oxyd- bzw. Aluminiumschichten Spannungen erzeugen, welche den Träger in unerwünschter Weise entweder nach oben oder nach unten biegen. Aus diesem Grund wird versucht, die durch das Oxyd und das Aluminium erzeugten Spannungen gegeneinander zu kompensieren, um ein möglichst spannungsfreies Endprodukt herzustellen, welches die angestrebte Sensorfunktion (z.B. Temperaturmessungen) ausführen kann.

ZUSAMMENFASSUNG DER ERFINDUNG

Mit dieser Erfindung ist unter anderem beabsichtigt, sich eine bislang nicht genützte Eigenschaft des ECE-Verfahrens zu Nutze zu machen, um Membranen mit kontrollierten Spannungseigenschaften zu erzeugen. Dies geschieht durch Steuerung der Art, der Dosis und des Konzentrationsprofils des Dotierungsmaterials.

Eine Siliziummembran wird erzeugt durch Dotierung eines Siliziumsubstrats zur Bildung einer dotierten Schicht, deren Dicke mit der gewünschten Dicke der Membran übereinstimmt. Die Wahl des Dotierungsmaterials ist davon abhängig, ob Zugspannung oder Druckspannung erzeugt werden soll. Atome, die kleiner sind als Silizium, werden zur Erzeugung einer Zugspannung verwendet, während Atome, die größer sind als Silizium, zur Erzeugung einer Druckspannung verwendet werden. Die Dotierungskonzentration wird dann so gesteuert, daß ein vorgegebener Spannungsgrad in der dotierten Schicht erzielt wird. Die Dotierungskonzentration kann gleichmäßig sein, um eine isotrope Spannung in der Membran zu erzeugen. Viele haben auch ein Konzentrationsprofil in einer oder mehreren Richtungen, um die erwünschte Struktur einer anisotropen Spannung in der Membran zu bilden.

Nach Erzeugung der dotierten Schicht wird unter Anwendung der elektrochemischen Ätzstopptechnik eine Membran durch Wegätzen des Siliziumsubstrats unterhalb der erwünschten Membranfläche gebildet.

Ein Verändern von Spannungseigenschaften nach dem Ätzvorgang kann durch Zusetzen weiterer Dotierungsmaterialien der selben oder einer anderen Art durchgeführt werden.

## KURZBESCHREIBUNG DER ZEICHNUNG

Die Fig. 1a - 1e sind schematische Darstellungen aufeinanderfolgender Bearbeitungsschritte, die unter Anwendung des Verfahrens der vorliegenden Erfindung ausgeführt werden können.

## GENAUE BESCHREIBUNG DER BEVORZUGTEN AUSFÜHRUNGSFORM

Die Erfindung betrifft ein Verfahren zur Herstellung einer Siliziummembran mit vorbestimmten Spannungseigenschaften. In der folgenden Beschreibung werden nur zum Zweck der Erklärung, aber nicht als Einschränkung bestimmte Zahlen, Größen, Materialien etc. genannt, um ein Verstehen der vorliegenden Erfindung zu gewährleisten. Der mit dem Gebiet vertraute Fachmann wird erkennen, daß die vorliegende Erfindung auch ohne diese speziellen Details praktisch angewendet werden kann.

Bezugnehmend auf Fig. 1a ist das Ausgangsmaterial für das Verfahren nach der vorliegenden Erfindung ein Silizium-Wafer 10, je nach gewählter Dotierungssubstanz entweder ein n-Typ oder ein p-Typ. Ein p-Wafer wird für n-Dotierungsstanzen verwendet, und ein n-Wafer für p-Dotierungssubstanzen.

Wie in Figur 1b dargestellt, wird eine dotierte Schicht 12 unter Anwendung einer der hiefür bekannten Dotierungsmethoden (Diffusion, Ionenimplantation oder Epitaxie) gebildet. Die Wahl des Dotierungsmaterials ist von der Verwendung und dem gewünschten Spannungsgrad abhängig. Bor oder Phosphor sind zur Erzielung einer Zugspannung geeignet, während Antimon oder Zinn für eine Druckspannung vorteilhaft sind. Arsen, das einen atomaren Durchmesser besitzt, der annähernd dem von Silizium entspricht, ist für einen sehr niedrigen Spannungsgrad geeignet. Die Erfindung ist nicht auf diese Elemente begrenzt und schließt auch andere Atome mit ein, mit denen eine dotierte Schicht gebildet werden kann. Die vorher genannten Atome stellen jene Dotierungsatome dar, die bei der Halbleitererzeugung üblicherweise verwendet werden.

Der Spannungsgrad der Membran wird durch die Gesamtdosis der dem Wafer zugesetzten Dotierungssubstanz bestimmt, wie durch die folgende Formel dargestellt

$$(1) \qquad \sigma = \beta(E/(1-v))(D/t)$$

wobei

$\sigma$ die Membranspannung bezeichnet,
$\beta$ der Gitterkontraktionskoeffizient ist (der von dem verwendeten Dotierungsmaterial abhängig ist),
E und v elastische Konstanten von Silizium sind, nämlich Youngscher Elastizitätsmodul bzw. Poissonsche Zahl,
D die Gesamtdosis in Atomen pro $cm^2$ ist, und
t die Membrandicke ist.

Die in Gleichung (1) ausgedrückte Relation besitzt Gültigkeit, solange die Spannung unter jenem Niveau bleibt, ab dem Versetzungen stattfinden.

Weiters gilt, daß alle zusätzlichen Störspannungsquellen, wie atomare Störstellen oder Kristallfehler im Silizium, auf niedrigem Niveau gehalten werden müssen. Die Gleichung (1) setzt auch voraus, daß die ungeätzten Teile des Silizium-Wafers genügend starr sind, um eine Strukturverformung zu verhindern.

Die Größe (D/t) in der Gleichung (1) ist die durchschnittliche Dotierungskonzentration in der Membran. Die Formel zeigt, daß für ein vorgegebenes Dotierungsmaterial der Spannungsbereich durch den Bereich möglicher Dotierungskonzentrationen bestimmt wird. Wie bereits erwähnt, ist die Anwendung des ECE-Verfahrens nicht von der Verwendung eines bestimmten Dotierungsmaterials oder einem engen Bereich von Dotierungskonzentrationen abhängig, wie dies bei der p++ Ätzstopptechnik oder sonstigen Ätzverfahren der Fall ist. Daher ist das ECE-Verfahren für die Erzeugung von Membranen mit kontrollierten Spannungseigenschaften besonders gut geeignet.

Die obige Gleichung (1) drückt die durchschnittliche Spannung der ganzen Membran aus. Bei bestimmten Anwendungen ist es wünschenswert, nicht nur die Gesamtspannung in der Membran zu steuern, sondern auch das Spannungsprofil. So kann beispielsweise die Erzeugung einer Membran erwünscht sein, bei der die Spannung auf einer Oberfläche stärker ist als auf der anderen. Dabei wird die Dotierungssubstanz auf eine Weise aufgeprägt, daß ihre Konzentration auf einer Oberfläche größer ist als auf der anderen. Wenn das Dotierungskonzentrationsprofil nicht gleichmäßig über die Membran verteilt ist, wird die Spannung stellenweise je nach Dotierungskonzentration verschieden sein. Die lokale Spannung (als eine Funktion von z = Tiefe in die Membran) wird wie folgt ausgedrückt:

$$(2) \qquad \sigma(z) = \beta(E/(1-v)) C(z)$$

wobei C(z) die Dotierungskonzentration als eine Funktion der Tiefe ist und alle anderen Variablen dieselbe Bedeutung haben wie bei der Gleichung (1).

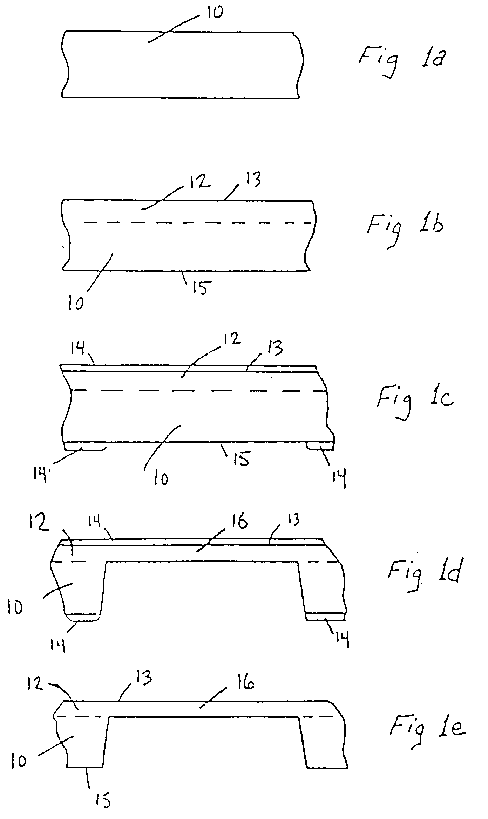

Nachdem die dotierte Schicht 12 wie vorher beschrieben gebildet worden ist, wird auf das Substrat eine geeignete Maskierung 14 aufgebracht, wie in Figur 1c dargestellt. Die Maskierung 14 bedeckt die gesamte Fläche 13 der dotierten Schicht 12 und von der gegenüberliegenden Fläche 15 den Teil, der außerhalb der Membranfläche liegt. Die Membran 16 wird dann durch Wegätzen des Substrats unter der Membranfläche unter Anwendung des bekannten ECE-Verfahrens geformt, wie in Fig.1d dargestellt. Nachdem der Ätzvorgang beendet ist, wird die Maskierung 14 durch ein Lösungsmittel oder andere geeignete Mittel entfernt, wie in Fig. 1e dargestellt.

Nach Bildung der Membran 16 ist es möglich, den Spannungsgrad durch Zusetzen weiterer Dotierungsatome zu verändern. Dieser Bearbeitungsschritt kann auch mit anderen Ätzstopptechniken als dem ECE-Verfahren durchgeführt werden, um Membranspannungen zu verändern, nachdem die Membranen gebildet worden sind.

Mit dieser Erfindung ist es weiters möglich, den Spannungsgrad abhängig von der Lage auf der Waferfläche zu variieren. Unter Anwendung bekannter Dotierungsverfahren wird das Zusetzen verschiedener Dotierungsmaterialien oder das Erzielen unterschiedlicher Dotierungskonzentrationen in verschiedenen Flächenbereichen des Wafers ermöglicht. Daher können Membrane mit unterschiedlichem Spannungsgrad auf demselben Wafer erzeugt werden, bzw. eine einzelne Membran mit einer Spannung, die sich als eine Funktion der Lage auf der Membranfläche verändert.

Beispiele:

1. Es wurde eine Membran mit einer Dicke von 2,8 Mikrometer erzeugt, wobei ein p-Silizium-Wafer verwendet wurde, in den Phosphor auf eine Gesamtdosis von $3{,}8 \times 10^{15}$ Atomen/cm$^2$ diffundiert wurde. Die gemessene Spannung betrug $6{,}1 \times 10^7$ dyn pro cm$^2$ (1 dyn = $10^{-5}$ N). Der vorausberechnete Wert unter Zugrundelegung von Gleichung (1) beträgt $6{,}0 \times 10^7$. Dieser basiert auf der Verwendung der Werte $1{,}5 \times 10^{12}$ dyn/cm$^2$ und $3{,}0 \times 10^{-24}$ cm$^3$/Atom für die Größen E/(1-v) bzw. β.

2. Es wurde eine Membran mit einer Dicke von 2,2 Mikrometer erzeugt, wobei ein p-Wafer mit einer Phosphorlonen-Implantation von $1{,}0 \times 10^{14}$ Atomen/cm$^2$ verwendet wurde. Die gemessene Spannung lag unterhalb der Auflösungsgrenze der verwendeten Meßeinrichtung (unter $5 \times \times 10^6$ dyn/cm$^2$). Dies stimmt mit dem vorausberechneten Wert von $2{,}0 \times 10^6$ überein.

3. Es wurde eine Membran mit einer Dicke von 2,6 Mikrometer erzeugt, wobei ein p-Wafer mit einer Phosphor-Ionen-Implantation von $1{,}0 \times 10^{16}$ Ato-

men/cm$^2$ verwendet wurde. Die gemessene Spannung betrug $1{,}3 \times 10^8$ dyn/cm$^2$, im Vergleich zum vorausberechneten Wert von $1{,}7 \times 10^8$.

Die Erfindung ist nicht auf die vorhergehenden Ausführungsbeispiele beschränkt, außer wie in den beigefügten Patentansprüchen ausgeführt.

**Patentansprüche**

1. Verfahren zur Herstellung einer Siliziummembran, insbesondere einer Silizium-Projektionsmaske für Röntgen- oder Korpuskularstrahllithographie, wie z.B. Elektronen- oder Ionenstrahllithographie, welches die folgenden Schritte aufweist:

   a) Auswählen eines Siliziumsubstrats von einem vorgegebenen ersten elektrischen Leitfähigkeitstyp, d.h. n- oder p-leitend, wobei das Substrat eine erste und eine gegenüberliegende zweite Seite besitzt,

   b) Auswählen einer Dotierungssubstanz von vorgegebenem zweiten elektrischen Leitfähigkeitstyp mit umgekehrter Polarität zum ersten elektrischen Leitfähigkeitstyp, d.h. p- oder n-leitend,

   c) Bilden einer mit dieser Dotienungssubstanz dotierten Schicht mit vorbestimmter Dicke und Dotierungskonzentration, angrenzend an die erste Seite des Substrates,

   d) elektrochemisches Ätzen eines Teils der zweiten Seite des Substrats bis zu einer Grenzzone der dotierten Schicht, wodurch eine Membran mit einer Dicke gebildet wird, die etwa der Dicke der dotierten Schicht entspricht,

   **dadurch gekennzeichnet, daß**
   bei Ausführen der Schritte b) und c) die Auswahl der Dotierungssubstanz derart getroffen wird, daß innerhalb der dotierten Schicht in Abhängigkeit von der Dicke und Dotierungskonzentration eine vorbestimmte, von Null verschiedene mechanische Spannung erzeugt wird, wobei Dotierungsatome der Dotierungssubstanz, die kleiner als die Siliziumatome sind, innerhalb der dotierten Schicht eine Zugspannung erzeugen und Dotierungsatome, die größer als die Siliziumatome sind, innerhalb der dotierten Schicht eine Druckspannung erzeugen, und

   e) die Membran nach Ausführen des Schrittes (d) mit einer weiteren Dotierungssubstanz dotiert wird, um die Spannungseigenschaften der Membran nach dem elektrochemischen Ätzvorgang zu verändern.

2.  Verfahren nach Anspruch 1, **dadurch gekennzeichnet, daß** die Dotierungssubstanz zum Ausliihren des Schrittes e) die gleiche Substanz wie jene zum Ausführen des Schrittes c) ist.

3.  Verfahren nach Anspruch 1, **dadurch gekennzeichnet, daß** die Dotierungssubstanz zum Ausführen des Schrittes e) eine andere Substanz als jene zum Ausführen des Schrittes c) ist.

4.  Verfahren nach Anspruch 2 oder 3, **dadurch gekennzeichnet, daß** die dotierte Schicht durch einen Diffusionsprozeß gebildet wird.

5.  Verfahren nach Anspruch 2 oder 3, **dadurch gekennzeichnet, daß** die dotierte Schicht durch einen Ionenimplantationsprozeß gebildet wird.

6.  Verfahren nach Anspruch 2 oder 3, **dadurch gekennzeichnet, daß** die dotierte Schicht durch Epitaxie gebildet wird.

7.  Verfahren nach einem der Ansprüche 1 bis 6, **dadurch gekennzeichnet, daß** die dotierte Schicht eine gleichmäßige Konzentration der Dotierungssubstanz aufweist.

8.  Verfahren nach einem der Ansprüche 1 bis 6, **dadurch gekennzeichnet, daß** die dotierte Schicht eine Konzentration der Dotierungssubstanz aufweist, die eine Funktion der Tiefe unterhalb der ersten Seite des Substrates ist.

9.  Verfahren nach einem der Ansprüche 1 bis 6, **dadurch gekennzeichnet, daß** die dotierte Schicht eine Konzentration der Dotierungssubstanz aufweist, die eine Funktion der Lage auf der ersten Seite ist.

## Claims

1.  Method for producing a silicium membrane, in particular a silicium projection mask for X-ray or corpuscular radiation lithography, for example, electron or ion beam lithography, comprising the following steps:

    a) selecting a silicium substrate of a predetermined first electric conductivity type, ie n- or p-type conduction, wherein the substrate has a first and an opposite second side,

    b) selecting a doping substance of a predetermined second electric conductivity type with reversed polarity to the first electric conductivity type, ie p- or n-type conduction,

    c) forming a doped layer from this doping substance, having a predetermined thickness and doping concentration, adjoining the first side of the substrate,

    d) electrochemically etching a part of the second side of the substrate as far as a border zone of the doped layer, wherein a membrane is formed of a thickness which approximately corresponds to the thickness of the doped layer,

    characterised in that,
    when carrying out the steps b) and c) the doping substance is selected in such a way that within the doped layer in dependence upon the thickness and doping concentration, a predetermined non-zero mechanical stress is produced, wherein doping atoms of the doping substance, which are smaller than the silicium atoms, produce a tensile stress within the doped layer, and doping atoms, which are larger than the silicium atoms, produce a compressive stress within the doped layer, and

    e) after step (d) is carried out, the membrane is doped with a further doping substance in order to change the stress properties of the membrane after the electrochemical etching process.

2.  Method according to claim 1, characterised in that the doping substance for carrying out step e) is the same substance as that for carrying out step c).

3.  Method according to claim 1, characterised in that the doping substance for carrying out step e) is a different substance from that for carrying out step c).

4.  Method according to claim 2 or 3, characterised in that the doped layer is formed by a diffusion process.

5.  Method according to claim 2 or 3, characterised in that the doped layer is formed by an ion implantation process.

6.  Method according to claim 2 or 3, characterised in that the doped layer is formed by epitaxy.

7.  Method according to one of claims 1 to 6, characterised in that the doped layer comprises a uniform concentration of the doping substance.

8.  Method according to one of claims 1 to 6, characterised in that the doped layer comprises a concentration of the doping substance, which is a function of the depth below the first side of the substrate.

9. Method according to one of claims 1 to 6, characterised in that the doped layer comprises a concentration of the doping substance which is a function of the position on the first side.

**Revendications**

1. Procédé de fabrication d'une membrane de silicium, en particulier d'un masque de projection en silicium pour lithographie par rayonnement X ou par rayonnement corpusculaire, comme, par exemple, la lithographie par faisceau d'électrons ou par faisceau ionique, comportant les étapes suivantes qui consistent à :

a) choisir un substrat de silicium ayant un premier type prédéfini de conductibilité électrique, c'est-à-dire à conductibilité du type N ou du type P, le substrat possédant une première face et une deuxième face opposée à la première,
b) choisir une substance de dopage du deuxième type prédéfini de conductibilité électrique avec une polarité opposée à celle du premier type de conductibilité électrique, c'est-à-dire à conductibilité du type P ou du type N,
c) former, avec cette substance de dopage, une couche dopée ayant une épaisseur prédéfinie et une concentration de dopant prédéfinie, qui est contiguë à la première face du substrat,
d) effectuer une attaque électrochimique d'une partie de la deuxième face du substrat jusqu'à une zone limite de la couche dopée, grâce à quoi une membrane est formée, dont l'épaisseur correspond approximativement à l'épaisseur de la couche dopée,

caractérisé en ce que, pour effectuer les étapes b) et c), on choisit la substance de dopage de manière telle qu'une tension mécanique prédéfinie différente de zéro soit produite à l'intérieur de la couche dopée, d'une manière dépendante de l'épaisseur et de la concentration de dopant, les atomes dopants de la substance de dopage qui sont plus petits que les atomes de silicium produisant une contrainte de traction à l'intérieur de la couche dopée, et les atomes dopants qui sont plus gros que les atomes de silicium produisant une contrainte de compression à l'intérieur de la couche dopée, et

e) après avoir effectué l'étape d), on dope la membrane avec une autre substance de dopage pour modifier les propriétés de tension de la membrane après l'opération d'attaque électrochimique.

2. Procédé selon la revendication 1, caractérisé en ce que la substance de dopage pour effectuer l'étape e) est la même substance que celle utilisée pour effectuer l'étape c).

3. Procédé selon la revendication 1, caractérisé en ce que la substance de dopage pour effectuer l'étape e) est une substance différente de celle utilisée pour effectuer l'étape c).

4. Procédé selon la revendication 2 ou 3, caractérisé en ce que la couche dopée est formée au moyen d'un procédé de diffusion.

5. Procédé selon la revendication 2 ou 3, caractérisé en ce que la couche dopée est formée au moyen d'un procédé d'implantation d'ions.

6. Procédé selon la revendication 2 ou 3, caractérisé en ce que la couche dopée est formée par épitaxie.

7. Procédé selon l'une des revendications 1 à 6, caractérisé en ce que la couche dopée présente une concentration homogène de substance de dopage.

8. Procédé selon l'une des revendications 1 à 6, caractérisé en ce que la couche dopée présente une concentration de substance de dopage qui est fonction de la profondeur au-dessous de la première face du substrat.

9. Procédé selon l'une des revendications 1 à 6, caractérisé en ce que la couche dopée présente une concentration de substance de dopage qui est fonction de la position sur la première face.

Fig 1a

Fig 1b

Fig 1c

Fig 1d

Fig 1e